# EUROPÄISCHE PATENTSCHRIFT

(11) **EP 2 534 685 B1**
(45) Veröffentlichungstag und Bekanntmachung des Hinweises auf die Patenterteilung: **29.04.2015**
(21) Anmeldenummer: 11706194.5
(22) Anmeldetag: 10.02.2011
(51) Int. Cl.: H01L 23/482, H01L 29/423

(54) **SKALIERBARER AUFBAU FÜR LATERALE HALBLEITERBAUELEMENTE MIT HOHER STROMTRAGFÄHIGKEIT**
SCALABLE CONSTRUCTION FOR LATERAL SEMICONDUCTOR COMPONENTS HAVING HIGH CURRENT-CARRYING CAPACITY
STRUCTURE ÉCHELONNÉE POUR COMPOSANTS SEMI-CONDUCTEURS LATÉRAUX À COURANT ADMISSIBLE ÉLEVÉ

(30) Priorität: 10.02.2010 DE 102010001788
(43) Veröffentlichungstag der Anmeldung: 19.12.2012
(73) Patentinhaber: Forschungsverbund Berlin E.V., 12489 Berlin (DE)
(72) Erfinder: HILT, Oliver, 15566 Schöneiche (DE); WUERFL, Hans-Joachim, 15738 Zeuthen (DE)
(74) Vertreter: Gulde & Partner
(86) Internationale Anmeldenummer: PCT/EP2011/051985
(87) Internationale Veröffentlichungsnummer: WO 2011/098534

(56) Entgegenhaltungen:
- EP-A2- 1 471 581
- WO-A1-2011/014951
- US-A1- 2004 084 776
- US-A1- 2005 133 829
- US-A1- 2008 157 209
- "Field-effect transistor output driver", IBM TECHNICAL DISCLOSURE BULLETIN, INTERNATIONAL BUSINESS MACHINES CORP. (THORNWOOD), US, Bd. 28, Nr. 8, 1. Januar 1986 (1986-01-01) , XP002088269, ISSN: 0018-8689

## Beschreibung

Die Erfindung betrifft einen lateralen Transistor mit hoher Stromtragfähigkeit, gemäß dem Oberbegriff des Anspruchs 1, sowie ein Verfahren zur Herstellung eines Transistors gemäß dem Oberbegriff des Anspruchs 8.

Galliumnitrid-basierte Transistoren können durch einen Kontakt zwischen einer Galliumnitrid-(GaN-)Schicht und einer Aluminiumgalliumnitrid-(AlGaN-)Schicht eine stark leitfähige Schicht an der AlGaN/GaN-Grenzfläche aufweisen, die sich als Transistorkanal eines Feldeffekttransistors einsetzen lässt. Die leitfähige Schicht wird über zwei auf der Halbleiteroberfläche aufgebrachte Metallflächen kontaktiert, welche Source und Drain des Transistors darstellen. Eine zwischen Source und Drain auf die Oberfläche aufgebrachte Steuerelektrode dient als Gate des Feldeffekttransistors. Kennzeichnend für einen derartigen Aufbau ist, dass alle drei Transistoranschlüsse über die Oberseite des Halbleiters zugänglich sind. Außerdem ist charakteristisch, dass der Strom im Transistorkanal parallel zur Halbleiteroberfläche fließt. Bei einem derartigen Transistoraufbau spricht man von einem lateralen Bauelement. Im Gegensatz dazu werden viele Transistoren z. B. in der Siliziumtechnologie als vertikale Bauelemente entworfen. Dabei ist mindestens ein Transistoranschluss - üblicherweise Source oder Drain - von der Unterseite des Halbleitersubstrats kontaktierbar.

Die Entwicklung GaN-basierter Feldeffekttransistoren mit einem Schottkymetall als Gate (HEMT) oder einem durch ein Dielektrikum isolierten Metall als Gate (MISFET) ist für Anwendungen als Mikrowellenverstärker weit fortgeschritten. Derartige Bauelemente haben typischerweise Gateweiten unterhalb 100 mm. Die Anordnung der Source-, Drain- und Gateelektroden auf der Halbleiteroberfläche wird dabei durch die Besonderheiten der elektrischen Signalausbreitung im Frequenzbereich der Mikrowellen bestimmt und führt zu untereinander liegenden abwechselnden Source- und Drainfeldern, zwischen denen die Gateelektroden liegen. Diese sind in der Regel seitlich der Source- und Drainfelder auf einer Seite elektrisch leitend miteinander verbunden.

Die Entwicklung GaN-basierter Transistoren als Schalttransistoren in der Leistungselektronik ist noch nicht so weit fortgeschritten. Hier werden Transistoren mit einer höheren Pulsstromtragfähigkeit, typischerweise oberhalb 50 A, und einer größeren Gateweite von typischerweise oberhalb 100 mm benötigt. Da die angestrebten Schaltfrequenzen in der Leistungselektronik deutlich unterhalb 1 GHz liegen und somit die Länge der elektromagnetischen Wellen als sehr groß gegenüber den Transistorabmessungen betrachtet werden kann, ergeben sich hier größere Freiheiten in der Anordnung der Source-, Drain- und Gateelektroden auf der Halbleiteroberfläche.

Es ist somit erkennbar, dass sich der laterale Aufbau eines GaN-Transistors für Schaltzwecke in der Leistungselektronik sowohl von dem Aufbau eines GaN-Mikrowellentransistors unterscheiden kann, als auch von dem Aufbau eines vertikalen Schalttransistors für die Leistungselektronik. Besondere Aufmerksamkeit muss der effizienten Ausnutzung der Halbleiterfläche zukommen, da GaN-basierte Halbleiter besonders hohe Kosten pro Halbleiterfläche aufweisen. EP 1471581A1 beschreibt einen MOS Transistor mit einer maschenartigen Gateelektrode, die eine Vielzahl langgezogener und sich zueinander parallel erstreckender Drähte umfasst, die eine weitere Vielzahl langgezogener und sich zueinander parallel erstreckender Drähte überschneiden, so dass ein Array von Gatüberschneidungen über der Oberfläche eines Substrats sowie ein Array von Sounrce/Drain Regionen definiert ist.

Es ist eine Aufgabe der vorliegenden Erfindung, einen Transistoraufbau anzugeben, welcher die zur Verfügung stehende Halbleiterfläche möglichst effizient ausnutzt und bei gegebener Halbleiterfläche eine möglichst hohe Stromtragfähigkeit erzielt. Der Transistoraufbau soll so strukturiert sein, dass eine einfache Skalierung der Stromtragfähigkeit der Transistoren möglich ist. Die elektrisch aktiven Gebiete sollen so angeordnet werden, dass die im Transistorbetrieb sich einstellende Temperatur der elektrisch aktiven Gebiete auf dem Halbleiter möglichst konstant verteilt ist.

Diese Aufgaben werden durch einen Transistor mit den in Anspruch 1 genannten Merkmalen bzw. ein Verfahren mit den in Anspruch 8 genannten Merkmalen gelöst. Vorteilhafte Ausführungsformen weisen in den abhängigen Ansprüchen genannte Merkmale auf.

In dem erfindungsgemäßen Transistor fließen die hohen Quellen- und Senkenströme der zusammen geschalteten Transistorzellen nicht auf der Chipebene, sondern vorzugsweise auf einer Leiterplatine. Somit wird ein wesentlicher Teil der Transistorverdrahtungsebenen von der teuren Halbleiteroberfläche auf eine vergleichsweise sehr preiswerte Leiterplatine verschoben. Auch können auf Leiterplatinen besonders einfach dicke Kupferbahnen erzeugt werden, die bei gleichem Querschnitt die Leitfähigkeit von Leiterbahnen, welche durch Aufdampf- oder Sputterprozesse auf der Halbleiteroberfläche realisierbar sind, übersteigen.

Auf der Waferebene - das heißt vor der Flip-Chip-Montage des Transistors auf der Leiterplatine - sind die einzelnen Transistorzellen unabhängig voneinander funktionsfähig. Dies bietet die Möglichkeit, die elektrische Charakterisierung des Transistors durch die elektrische Charakterisierung seiner Transistorzellen vorzunehmen. Die Stromtragfähigkeit des eingesetzten Messaufbaus muss dann nur den Transistorzellen entsprechen, Defekte lassen sich auf einzelne Transistorzellen eingrenzen, und die Parameterstreuung einzelner Zellen des Transistors kann bestimmt werden. Auch können bei Transistoren mit sehr vielen Zellen einzelne defekte Zellen durch das Weglassen der entsprechenden Bumps aus dem Transistor eliminiert werden.

Die Erfindung wird nachfolgend anhand der Zeichnungen näher erläutert. Es zeigen:
- Figur 1: eine schematische Querschnittsansicht eines Transistors;
- Figur 2: eine Aufsicht eines Beispiels einer Transistorzelle, das nicht unter den Schutzbereich der Ansprüche fällt;
- Figur 3: eine Aufsicht eines Ausführungsbeispiels erfindungsgemäßer Transistorzellen; und
- Figur 4: eine Aufsicht eines weiteren Ausführungsbeispiels erfindungsgemäßer Transistorzellen.

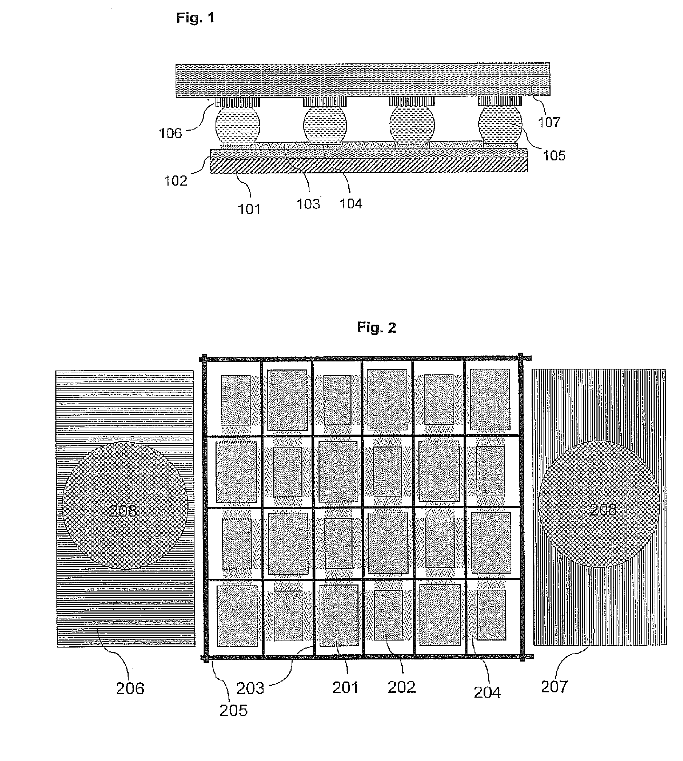

Fig. 1 zeigt exemplarisch den Querschnitt eines Transistors. Der Transistor ist auf der Halbleiteroberfläche 102, die sich auf einem Substrat 101 befinden kann, in mehrere identische Transistorzellen 103 aufgeteilt, welche für sich genommen funktionsfähige Transistoren darstellen. Dabei sind die Steuerelektroden aller Transistorzellen des Transistors miteinander auf der Halbleiteroberfläche verbunden. Eine vollständige Verbindung der Quellen und Senken der Transistorzellen untereinander erfolgt nicht - wie sonst üblich - auf der Halbleiteroberfläche. Die Quellen- und Senkenkontaktfelder 104 der Transistorzellen werden jeweils mit einem Bump 105 versehen. Auch wird der Steuerelektrodenkontakt des kompletten Transistors mit einem oder mehreren Bumps versehen. Die Bumps sind in einem Flip-Chip-Verfahren mit Leiterbahnen 106 auf einer in der elektronischen Aufbautechnologie üblichen Leiterplatine 107 verbunden, die bevorzugt eine hohe Wärmeleitfähigkeit aufweist. Die Leiterbahnen auf der Leiterplatine sind derart angeordnet, dass sie alle Quellen- bzw. Senkenbumps parallel so verschalten, dass alle Transistorzellen einen parallel geschalteten Transistor mit hoher Stromtragfähigkeit ergeben. Die Größe der Transistorzellen ist so gewählt, dass deren Stromtragfähigkeit an die der Bump-Kontakte angepasst ist.

Fig. 2, 3 und 4 zeigen Aufsichten von Transistorzellen. Die Transistorzellen sind auf der Halbleiteroberfläche als abwechselnde Folge von Quellenfeldern 201, 301, 401 und Drainfeldern 202, 302, 402 aufgebaut, die durch eine netzartig angeordnete zusammenhängende Steuerelektrode 203, 303, 403 voneinander getrennt sind. Somit ist ein aktives Transistorgebiet 204 an allen Kanten der Source- und Drainfelder möglich, sofern das entsprechende Feld nicht an einer Außenseite der Transistorzelle liegt. Die Steuerelektroden 203, 303, 403 unterschiedlicher Transistorzellen sind durch auf der Halbleiterebene angeordnete Metallstreifen 205, 304, 404 miteinander elektrisch leitend verbunden.

In Fig. 2 sind die Quellen- und Senkenfelder 201 und 202 rechteckig. Die Quellenkontaktfelder 206 und Senkenkontaktfelder 207 mit den Bumps 208 liegen an entgegengesetzten Seiten des Feldes mit den aktiven Transistorgebieten. Die elektrisch leitende Verbindung zwischen den Quellen- und Senkenfeldern und den zugehörigen Kontaktfeldern ist mit Metallbrücken realisiert. Diese können als Luftbrücke oder als Brücke über ein Dielektrikum realisiert sein, welches über den zu kontaktierenden Quellen- oder Senkenfeldern geöffnet ist.

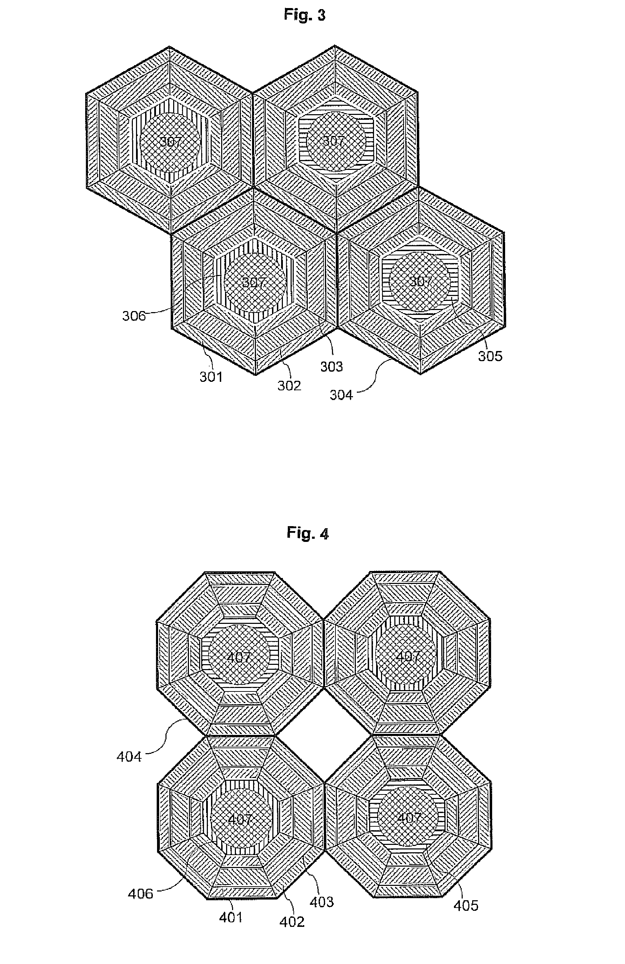

In einer ersten, in Fig. 3 dargestellten und einer weiteren in Fig. 4 dargestellten möglichen Ausführung sind die Quellen- und Senkenfelder 301, 401 bzw. 302, 402 konzentrisch um ein Quellen- oder Senkenkontaktfeld 305, 405 bzw. 306, 406 mit Bump 307, 407 angeordnet. Die Steuerelektroden 303, 403 ergeben ein Netzwerk aus konzentrischen und radialen Metallisierungen, welche über auf der Halbleiterebene angeordnete Metallstreifen 304, 404 mit den Steuerelektroden der übrigen Transistorzellen des Transistors elektrisch leitend verbunden sind. Der Vorteil der in Fig. 3 und 4 dargestellten Ausführungen liegt in dem minimierten Wärmewiderstand zwischen dem aktiven Transistorgebiet und dem Bump, der dann besonders effizient zur Wärmeabfuhr der Verlustwärme des Transistors zur Leiterplatine hin genutzt werden kann. Auch ermöglicht es die konzentrische Anordnung der Steuerelektroden deren Abstand zueinander mit zunehmendem Abstand vom Bump derart zu erhöhen, dass sich die sich beim Transistorbetrieb einstellende Temperatur auf der Halbleiteroberfläche mit zunehmendem Abstand zum Bump nicht erhöht. Die Kontaktierung der Quellen- und Senkenfelder erfolgt analog zu Figur 2.

Dabei werden die Quellenfelder in Transistorzellen, die ein Quellenkontaktfeld aufweisen, mit diesem Quellenkontaktfeld verbunden; die Quellenfelder in Transistorzellen, die ein Senkenkontaktfeld aufweisen, werden mit dem Quellenkontaktfeld einer benachbarten Transistorzelle verbunden. Entsprechendes gilt für die Senkenfelder.

Ist die Anordnung der Steuerelektroden, wie in Fig. 3 anhand von vier Transistorzellen dargestellt, hexagonal, so kann die Halbleiteroberfläche lückenlos mit Quellen- und Senkenfeldern mit in der Mitte liegenden Quellen- oder Senkenbumps 307 belegt werden.

Ist die Anordnung der Steuerelektroden, wie in Fig. 4 anhand von vier Transistorzellen dargestellt, oktagonal, so ist eine Transistorzelle mit zentralem Quellenkontaktfeld 405 zu allen Seiten von Transistorzellen mit zentralem Senkenkontaktfeld 406 umgeben und umgekehrt. Dies hat den Vorteil, dass die einzelnen Quellen- und Senkenfelder 401 und 402 besonders einfach über eine Metallbrücke mit den Quellen- und Senkenkontaktfeldern 405 und 406 verbunden werden können.

Die für die in Fig. 4 dargestellte oktagonale Ausführung beschriebenen Vorteile gelten für alle bumpzentrierten polygonalen Ausführungen, bei denen die Kantenanzahl der Polygone ganzzahlig durch 4 teilbar ist. Andere Ausführungen der lateralen Anordnungen der Quellen- und Senkenfelder mit den dazwischen liegenden Steuerelektroden sind möglich.

Jede der beschriebenen Ausführungen lässt sich auch auf einen erfindungsgemäßen Diodenaufbau übertragen. Hierzu sind jeweils die Steuerelektroden und ihre Kontakte wegzulassen und die Quellenfelder durch Kathodenfelder, die Quellenkontaktfelder durch Kathodenkontaktfelder, die Senkenfelder durch Anodenfelder und die Senkenkontaktfelder durch Anodenkontaktfelder zu ersetzen. Die Kathodenkontaktfelder werden jenseits der Halbleiteroberfläche miteinander leitend zu einer Kathode verbunden, und die Anodenkontaktfelder werden jenseits der Halbleiteroberfläche miteinander leitend zu einer Anode verbunden. Dadurch entsteht eine Diode mit hoher Stromtragfähigkeit und effizienter Ausnutzung der Halbleiteroberfläche.

### BEZUGSZEICHENLISTE

- 101: Substrat
- 102: Halbleiteroberfläche
- 103: Transistorzelle
- 104: Quellen-/Senkenkontaktfeld
- 105: Bump
- 106: Leiterbahn
- 107: Leiterplatine
- 201, 301, 401: Quellenfeld
- 202, 302, 402: Senkenfeld
- 203, 303, 403: Steuerelektrode
- 204: aktives Transistorgebiet
- 205, 304, 404: Metallstreifen
- 206, 305, 405: Quellenkontaktfeld
- 207, 306, 406: Senkenkontaktfeld
- 208, 307, 407: Bump

## Patentansprüche

1. Transistor, umfassend:
mindestens eine erste und eine benachbarte, zweite Transistorzelle (103), je umfassend:
ein Kontaktfeld (305, 306, 405, 406), welches mindestens einen Bump (105, 208, 307, 407) aufweist, der mit einer Leiterplatine (107) leitend verbindbar ist,
eine Steuerelektrode (303, 403), die sich aus einem Netzwerk aus zu dem Kontaktfeld konzentrischen und radialen Metallisierungen ergibt;
eine Vielzahl von Quellenfeldern (301, 401); und
eine Vielzahl von Senkenfeldern (302, 402),
wobei die Quellenfelder (301, 401) und die Senkenfelder (302, 402) konzentrisch um das Kontaktfeld (305, 306, 405, 406) in abwechselnder Reihenfolge und durch die Steuerelektrode von einander getrennt angeordnet sind,
wobei
die Steuerelektrode (303, 403) mindestens eines der Quellenfelder (201, 301, 401) und mindestens eines der Senkenfelder (202, 302, 402) vollständig umschließt,
wobei die Quellenfelder (301, 401) der ersten und der zweiten Transistorzelle leitend mit dem Kontaktfeld (305, 405) der ersten Transistorzelle und die Senkenfelder (302, 402) der ersten und der zweiten Transistorzelle leitend mit dem Kontaktfeld (306, 406) der zweiten Transistorzelle verbunden sind.

2. Transistor gemäß Anspruch 1,
**dadurch gekennzeichnet, dass**
die konzentrischen Metallisierungen mit zunehmendem Abstand vom Bump zueinander zunehmend beabstandet sind, so dass die sich beim Transistorbetrieb einstellende Temperatur der Steuerelektrode (303, 403) mit zunehmendem Abstand zu dem mindestens einen Bump (307, 407) nicht zunimmt.

3. Transistor gemäß einem der Ansprüche 1 oder 2,
**dadurch gekennzeichnet, dass**
die Steuerelektrode (303) eine hexagonale Anordnung aufweist.

4. Transistor gemäß einem der Ansprüche 1 bis 3,
**dadurch gekennzeichnet, dass**
die Steuerelektrode (403) eine polygonale Anordnung aufweist, wobei die Kantenanzahl der Polygone ein ganzzahliges Vielfaches von 4 ist.

5. Transistor gemäß einem der Ansprüche 1 bis 4 mit einer Vielzahl von ersten und benachbarten, zweiten Transistorzellen, wobei die Transistorzellen (103) auf einer Halbleiteroberfläche (102) angeordnet sind ,
wobei
die Bumps (307, 407) der Kontaktfelder (305, 405) der ersten Transistorzellen über Leiterbahnen auf einer Leiterplatine (107) miteinander leitend verbunden sind; und die Bumps (307, 407) der Kontaktfelder (306, 406) der zweiten Transistorzellen über Leiterbahnen auf der Leiterplatine (107) miteinander leitend verbunden sind.

6. Transistor gemäß Anspruch 5,
**dadurch gekennzeichnet, dass**
die Transistorzellen (103) auf der Halbleiteroberfläche (102) aneinander angrenzend angeordnet sind.

7. Transistor gemäß einem der Ansprüche 5 bis 6,
**dadurch gekennzeichnet, dass**
die Steuerelektroden (203, 303, 403) der Transistorzellen (103) auf einem anderen Substrat miteinander leitend verbunden sind als die Quellenkontaktfelder (206, 305, 405) und die Senkenkontaktfelder (207, 306, 406).

8. Verfahren zur Herstellung eines Transistors, umfassend:
Bereitstellen einer Halbleiteroberfläche (102);
Ausbilden, auf der Halbleiteroberfläche (102), mindestens einer ersten und einer benachbarten, zweiten Transistorzelle (103) von denen jede eine Steuerelektrode (303, 403), eine Vielzahl von Quellenfeldern und eine Vielzahl von Senkenfeldern umfasst,
und
leitendes Verbinden der Steuerelektroden (303, 403) miteinander, Ausbilden eines Kontaktfelds (305, 405, 306, 406) in jeder Transistorzelle (103);
leitendes Verbinden der Quellenfelder (301, 401) der ersten und der zweiten Transistorzelle mit dem Kontaktfeld der ersten Transistorzelle, so dass jede erste Transistorzelle ein Quellenkontaktfeld (305, 405) aufweist;
leitendes Verbinden der Senkenfelder (302, 402) der ersten und der zweiten Transistorzelle mit dem Kontaktfeld der zweiten Transistorzelle, so dass jede zweite Transistorzelle ein Senkenkontaktfeld (306, 406) aufweist;
Ausbilden mindestens eines Bumps (307, 407) auf jedem der Quellenkontaktfelder (305, 405) und auf jedem der Senkenkontaktfelder (306, 406);
Bereitstellen einer Leiterplatine (107);
leitendes Verbinden der Bumps (307, 407) der Quellenkontaktfelder (305, 405) miteinander über Leiterbahnen auf der Leiterplatine (107); und
leitendes Verbinden der Bumps (307, 407) der Senkenkontaktfelder (306, 406) miteinander über weitere Leiterbahnen auf der Leiterplatine (107),
wobei
in jeder der Vielzahl von Transistorzellen (103) die Steuerelektrode (203, 303, 403) so ausgebildet wird, dass sie mindestens eines der Quellenfelder (201, 301, 401) und mindestens eines der Senkenfelder (202, 302, 402) vollständig umschließt,
wobei sich jede Steuerelektrode (303, 403) aus einem Netzwerk aus konzentrischen und radialen Metallisierungen, die um den jeweiligen mindestens einen Bump herum angeordnet sind, ergibt und
wobei die Quellenfelder (301, 401) und die Senkenfelder (302, 402) konzentrisch um das Kontaktfeld (305, 306, 405, 406) in abwechselnder Reihenfolge und durch die Steuerelektrode von einander getrennt sind.

## Claims

1. Transistor, comprising:
at least a first and an adjacent second transistor cell (103), each of them comprising:
a contact field (305, 306, 405, 406) comprising at least one bump (105, 208, 307, 407) which can be conductively connected to a printed circuit board (107),
a control electrode (303, 403) which is the result of a network of metallizations concentric and radial with respect to the contact field;
a plurality of source fields (301, 401); and
a plurality of drain fields (302, 402),
wherein the source fields (301, 401) and the drain fields (302, 402) are arranged concentrically around the contact field (305, 306, 405, 406) in an alternating sequence and separated from each other by the control electrode,
wherein
the control electrode (303, 403) completely encloses at least one of the source fields (201, 301, 401) and at least one of the drain fields (202, 302, 402),
wherein the source fields (301, 401) of the first and the second transistor cell are conductively connected to the contact field (305, 405) of the first transistor cell, and the drain fields (302, 402) of the first and the second transistor cell are conductively connected to the contact field (306, 406) of the second transistor cell.

2. Transistor according to claim 1,
**characterized in that**
the concentric metallizations are increasingly spaced from each other with increasing distance from the bump, so that the temperature of the control electrode (303, 403) resulting from the transistor operation does not increase with increasing distance to the at least one bump (307, 407).

3. Transistor according to one of claims 1 or 2,
**characterized in that**
the control electrode (303) comprises a hexagonal arrangement.

4. Transistor according to any of claims 1 to 3,
**characterized in that**
the control electrode (403) comprises a polygonal arrangement, wherein the number of edges of the polygons is an integer multiple of 4.

5. Transistor according to any of claims 1 to 4, comprising a plurality of first and adjacent second transistor cells, wherein the transistor cells (103) are arranged on a semiconductor surface (102),
wherein
the bumps (307, 407) of the contact fields (305, 405) of the first transistor cells are conductively connected to each other via conductive tracks on a printed circuit board (107); and
the bumps (307, 407) of the contact fields (306, 406) of the second transistor cells are conductively connected to each other via conductive tracks on the printed circuit board (107).

6. Transistor according to claim 5,
**characterized in that**
the transistor cells (103) are arranged adjacent to each other on the semiconductor surface (102).

7. Transistor according to any of claims 5 to 6,
**characterized in that**
the control electrodes (203, 303, 403) of the transistor cells (103) are conductively connected to each other on another substrate than the source contact fields (206, 305, 405) and the drain contact fields (207, 306, 406).

8. Method for manufacturing a transistor, comprising:
providing a semiconductor surface (102);
forming at least a first and an adjacent second transistor cell (103) on the semiconductor surface (102), each of which comprises a control electrode (303, 403), a plurality of source fields and a plurality of drain fields,
and
conductively connecting the control electrodes (303, 403) to each other,
forming a contact field (305, 405, 306, 406) in each transistor cell (103);
conductively connecting the source fields (301, 401) of the first and the second transistor cell to the contact field of the first transistor cell, so that each first transistor cell comprises a source contact field (305, 405);
conductively connecting the drain fields (302, 402) of the first and the second transistor cell to the contact field of the second transistor cell, so that each second transistor cell comprises a drain contact field (306, 406);
forming at least one bump (307, 407) on each of the source contact fields (305, 405) and on each of the drain contact fields (306, 406);
providing a printed circuit board (107);
conductively connecting the bumps (307, 407) of the source contact fields (305, 405) to each other via conductive tracks on the printed circuit board (107); and
conductively connecting the bumps (307, 407) of the drain contact fields (306, 406) to each other via further conductive tracks on the printed circuit board (107),
wherein,
in each of the plurality of transistor cells (103), the control electrode (203, 303, 403) is formed in such a way that it encloses completely at least one of the source fields (201, 301, 401) and at least one of the drain fields (202, 302, 402),
wherein each control electrode (303, 403) is the result of a network of concentric and radial metallizations which are arranged around the respective at least one bump, and
wherein the source fields (301, 401) and the drain fields (302, 402) are arranged concentrically around the contact field (305, 306, 405, 406) in an alternating sequence and separated from each other by the control electrode.

## Revendications

1. Transistor, comprenant:
au moins une première et une deuxième cellule de transistor (103) adjacente, chacune d'elles comprenant :
un champ de contact (305, 306, 405, 406) comprenant au moins une bosse (105, 208, 307, 407) qui peut être connectée de manière conductrice à une carte de circuit imprimé (107),
une électrode de commande (303, 403) qui résulte d'un réseau de métallisations concentriques et radiales par rapport au champ de contact ;
une pluralité de champs de source (301, 401) ; et
une pluralité de champs de drain (302, 402),
dans lequel les champs de source (301, 401) et les champs de drain (302, 402) sont disposés de manière concentrique autour du champ de contact (305, 306, 405, 406) en une séquence alternante et séparés les uns des autres par l'électrode de commande,
dans lequel
l'électrode de commande (303, 403) entoure complètement au moins l'un des champs de source (201, 301, 401) et au moins l'un des champs de drain (202, 302, 402),
les champs de source (301, 401) de la première et de la deuxième cellule de transistor étant connectés de manière conductrice au champ de contact (305, 405) de la première cellule de transistor, et les champs de drain (302, 402) de la première et de la deuxième cellule de transistor étant connectés de manière conductrice au champ de contact (306, 406) de la deuxième cellule de transistor.

2. Transistor selon la revendication 1,
**caractérisé en ce que**
les métallisations concentriques sont espacées les unes des autres de manière croissante avec l'augmentation de la distance à la bosse de sorte que la température de l'électrode de commande (303, 403) résultant de l'opération du transistor n'augmente pas avec l'augmentation de la distance à l'au moins une bosse (307, 407).

3. Transistor selon l'une des revendications 1 ou 2,
**caractérisé en ce que**
l'électrode de commande (303) présente un arrangement hexagonal.

4. Transistor selon l'une des revendications 1 à 3,
**caractérisé en ce que**
l'électrode de commande (403) présente un arrangement polygonal, le nombre de bords des polygones étant un multiple entier de 4.

5. Transistor selon l'une des revendications 1 à 4, comprenant une pluralité de premières et de deuxièmes cellules de transistor adjacentes, les cellules de transistor (103) étant disposées sur une surface semi-conductrice (102),
dans lequel
les bosses (307, 407) des champs de contact (305, 405) des premières cellules de transistor sont connectées les unes aux autres de manière conductrice par des pistes conductrices sur une carte de circuit imprimé (107); et
les bosses (307, 407) des champs de contact (306, 406) des deuxièmes cellules de transistor sont connectées les unes aux autres de manière conductrice par des pistes conductrices sur la carte de circuit imprimé (107).

6. Transistor selon la revendication 5,
**caractérisé en ce que**
les cellules de transistor (103) sont disposées sur la surface semi-conductrice (102) de manière à être adjacentes les unes aux autres.

7. Transistor selon l'une des revendications 5 à 6,
**caractérisé en ce que**
les électrodes de commande (203, 303, 403) des cellules de transistor (103) sont connectées de manière conductrice sur un substrat différent de celui des champs de contact de source (206, 305, 405) et des champs de contact de drain (207, 306, 406).

8. Procédé de fabrication d'un transistor, comprenant :
prévoir une surface semi-conductrice (102) ;
former au moins une première et une deuxième cellule de transistor (103) adjacente sur la surface semi-conductrice (102), chacune d'elles comprenant une électrode de commande (303, 403), une pluralité de champs de source et une pluralité de champs de drain, et
connecter de manière conductrice les électrodes de commande (303, 403) les unes aux autres ;
former un champ de contact (305, 405, 306, 406) dans chaque cellule de transistor (103) ;
connecter de manière conductrice les champs de source (301, 401) de la première et de la deuxième cellule de transistor au champ de contact de la première cellule de transistor de sorte que chaque première cellule de transistor comprend un champ de contact de source (305, 405) ;
connecter de manière conductrice les champs de drain (302, 402) de la première et de la seconde cellule de transistor au champ de contact de la deuxième cellule de transistor de sorte que chaque deuxième cellule de transistor comprend un champ de contact de drain (306, 406),
former au moins une bosse (307, 407) sur chacun des champs de contact de source (305, 405) et sur chacun des champs de contact de drain (306, 406) ;
prévoir une carte de circuit imprimé (107) ;
connecter de manière conductrice les bosses (307, 407) des champs de contact de source (305, 405) les unes aux autres par des pistes conductrices sur la carte de circuit imprimé (107) ; et
connecter de manière conductrice les bosses (307, 407) des champs de contact de drain (306, 406) les unes aux autres par des autres pistes conductrices sur la carte de circuit imprimé (107),
dans lequel
l'électrode de commande (203, 303, 403) est formée dans chacune de la pluralité de cellules de transistor (103) de telle manière qu'elle entoure complètement au moins l'un des champs de source (201, 301, 401) et au moins l'un des champs de drain (203, 302, 402),
chaque électrode de commande (303, 403) résultant d'un réseau de métallisations concentriques et radiales arrangées autour de l'au moins une bosse respective, et
les champs de source (301, 401) et les champs de drain (302, 402) étant disposés de manière concentrique autour du champ de contact (305, 306, 405, 406) en une séquence alternante et séparés les uns des autres par l'électrode de commande.
